# EUROPÄISCHE PATENTSCHRIFT

(11) **EP 3 642 950 B1**
(45) Veröffentlichungstag und Bekanntmachung des Hinweises auf die Patenterteilung: **30.11.2022**
(21) Anmeldenummer: 18730334.2
(22) Anmeldetag: 07.06.2018
(51) Int. Cl.: H02M 1/44, H02M 7/00, H03H 7/54, H05K 7/00

(54) **BAUTEIL**
COMPONENT
PIÈCE

(30) Priorität: 20.06.2017 DE 102017113556
(43) Veröffentlichungstag der Anmeldung: 29.04.2020
(73) Patentinhaber: TDK Electronics AG, 81671 München (DE)
(72) Erfinder: BECK, Fabian, 4522 Rüttenen (CH)
(74) Vertreter: Epping - Hermann - Fischer
(86) Internationale Anmeldenummer: PCT/EP2018/065059
(87) Internationale Veröffentlichungsnummer: WO 2018/234057

(56) Entgegenhaltungen:
- CN-U- 202 076 118
- DE-U1-202016 102 587
- GB-A- 2 023 931
- JP-U- H0 638 224

## Beschreibung

Die vorliegende Erfindung betrifft ein Bauteil. Das Bauteil kann beispielsweise in einer Automotive Anwendung als EMV-Filter (EMV = Elektromagnetische Verträglichkeit, englisch: Electromagnetic Compatibility (EMC)) eingesetzt werden.

An ein solches Bauteil werden im Automotivebereich verschiedene Anforderungen gestellt. Das Bauteil sollte möglichst leicht sein, um eine Gewichtsoptimierung und eine Miniaturisierung zu ermöglichen. Ferner wird das Bauteil oft mit Anschlüssen oder Stromschienen verbunden, die hohen Temperaturen und/oder Vibrationen ausgesetzt sein können. Daher sollte das Bauteil möglichst unempfindlich gegen hohe Temperaturen oder mechanische Störungen sein.

Aufgabe der vorliegenden Erfindung ist es, ein verbessertes Bauteil anzugeben. Das Bauteil sollte beispielsweise für eine Verbindung mit Anschlüssen oder Stromschienen geeignet sein, die eine hohe Temperatur aufweisen.

Die Aufgabe wird durch ein Bauteil gemäß Anspruch 1 gelöst.

Es wird ein Bauteil vorgeschlagen, das einen ersten Bereich, der zur Durchführung von zumindest einer Stromschiene geeignet ist, und einen zweiten Bereich, in dem zumindest ein diskretes Bauelement angeordnet ist, aufweist, wobei der erste Bereich und der zweite Bereich durch einen Kühlbereich voneinander getrennt sind, der den ersten Bereich thermisch von dem zweiten Bereich entkoppelt.

Bei dem Bauteil kann es sich insbesondere um ein Filter-Bauteil handeln. Im Automotivbereich kann ein Filter-Bauteil mit Anschlüssen oder Stromschienen verbunden werden, die hohen Temperaturen und/oder Vibrationen ausgesetzt sein können. Das vorgeschlagene Filter-Bauteil ist unempfindlich gegen hohe Temperaturen, da der erste Bereich und der zweite Bereich durch den Kühlbereich voneinander getrennt sind, wobei der Kühlbereich den ersten Bereich thermisch von dem zweiten Bereich entkoppelt. Diese Ausgestaltung kann den zweiten Bereich des Filter-Bauteils auch vor Vibrationen der Stromschiene schützen.

Das Filter-Bauteil kann dazu ausgestaltet sein, ein elektrisches Signal abhängig von einer Frequenz in einer Amplitude und in einer Phasenlage zu verändern. Dadurch können unerwünschte Signalanteile abgeschwächt oder unterdrückt werden.

Durch die thermische Entkopplung des ersten Bereichs von dem zweiten Bereich kann sichergestellt werden, dass das zumindest eine diskrete Bauelement keiner überhöhten Temperatur ausgesetzt wird, selbst wenn die Stromschiene sehr heiß sein sollte. Das zumindest eine diskrete Bauelement kann somit durch den Kühlbereich vor einer überhöhten Temperatur der Stromschiene geschützt werden. Es muss somit keine konstruktionsbedingte Obergrenze für die Temperatur der Stromschiene bei dem Bauteil vorgegeben werden, um das zumindest eine diskrete Bauelement zu schützen. Vielmehr kann das Bauteil auch in Kombination mit einer Stromschiene verwendet werden, die sehr heiß ist.

Der erste Bereich und der zweite Bereich können räumlich durch den Kühlbereich voneinander getrennt sein. Dabei kann der erste Bereich auf einer Seite an den Kühlbereich angrenzen und der zweite Bereich kann auf einer zweiten Seite an den Kühlbereich angrenzen. Das Bauteil kann ein Gehäuse aufweisen, wobei sowohl der erste Bereich als auch der zweite Bereich als auch der Kühlbereich innerhalb des Gehäuses angeordnet sind.

Die Stromschiene muss nicht Bestandteil des Bauteils sein. Vielmehr kann das Bauteil ohne die Stromschiene hergestellt und vertrieben werden. Die Stromschiene kann Bestandteil einer Anwendung sein, beispielsweise einer weiteren Komponente, die mit dem Bauteil verschaltet wird.

Der erste Bereich kann eine Röhre aufweisen, durch die die zumindest eine Stromschiene hindurchgeführt werden kann. Der erste Bereich kann auch zur Durchführung von mehreren, beispielsweise zwei, Stromschienen geeignet sein. Der erste Bereich kann eine separate Röhre für jede der Stromschienen aufweisen.

Wird die zumindest eine Stromschiene durch den ersten Bereich hindurchgeführt, so erstreckt sich die zumindest eine Stromschiene von einem ersten Ende des ersten Bereichs zu einem zweiten Ende des ersten Bereichs. Dabei kann die zumindest eine Stromschiene innerhalb des Gehäuses des Bauteils verlaufen.

Der zweite Bereich kann eine Leiterplatte (englisch: Printed Circuit Board (PCB)) aufweisen. Auf der Leiterplatte kann das zumindest eine diskrete Bauelement angeordnet sein.

Der zweite Bereich kann mehrere diskrete Bauelemente aufweisen. Bei den diskreten Bauelementen kann es sich beispielsweise um Kondensatoren oder andere Bauelemente, beispielsweise Widerstände, handeln. Die diskreten Bauelemente können Bestandteil einer Filterschaltung sein. Auch die weiteren diskreten Bauelemente können auf der Leiterplatte angeordnet sein.

Der erste Bereich und der zweite Bereich können als thermisch voneinander entkoppelt angesehen werden, wenn der Kühlbereich dafür sorgt, dass in dem zweiten Bereich die Temperatur geringer ist als in dem ersten Bereich. Eine thermische Entkopplung der beiden Bereiche kann dann erfolgen, wenn der erste Bereich durch die Stromschiene erhitzt wird. Fließt beispielsweise ein Strom durch die Stromschiene, so können in dem ersten Bereich Temperaturen von deutlich über 100 °C erreicht werden. Der zweite Bereich kann als thermisch entkoppelt von dem ersten Bereich angesehen werden, wenn die Temperatur in dem zweiten Bereich um zumindest 10 °C geringer ist als die Temperatur in dem ersten Bereich. Vorzugsweise ist die Temperatur in dem zweiten Bereich um zumindest 25 °C geringer als im ersten Bereich. Alternativ kann der zweite Bereich als thermisch entkoppelt von dem ersten Bereich angesehen werden, wenn die Temperatur in dem zweiten Bereich um zumindest 40 °C geringer ist als eine Temperatur in dem ersten Bereich.

Der Kühlbereich kann dazu ausgestaltet sein, von dem ersten Bereich abgestrahlte Hitze aufzunehmen und abzuleiten. Auf diese Weise kann der Kühlbereich dafür zu sorgen, dass der erste Bereich den zweiten Bereich nur in geringem Maße erhitzt. Der Kühlbereich kann zu diesem Zweck mit einem Material gefüllt sein, das als thermischer Isolator wirkt. Beispielsweise kann der Kühlbereich mit Luft gefüllt sein. Alternativ oder ergänzend zu der Luftfüllung kann der Kühlbereich eine Schicht aus einem Kunststoff aufweisen. Sowohl Luft als auch die Kunststoffschicht wirken als thermische Isolatoren, die die von dem ersten Bereich abgestrahlte Hitze nicht in vollem Umfang an den zweiten Bereich weitergeben.

Auf diese Weise kann sichergestellt werden, dass das zumindest eine diskrete Bauelement, das im zweiten Bereich angeordnet ist, nicht durch von der Stromschiene abgestrahlte Hitze beschädigt wird. Dementsprechend kann der Kühlbereich es ermöglichen, dass das Bauteil auch bei Anwendungen eingesetzt wird, bei denen die Stromschiene sehr stark erhitzt wird. Dieses ist beispielsweise im Automotivebereich häufig der Fall. Dort kann die Stromschiene eine Stromdichte von 3 A/mm² und mehr aufweisen. Mit einer solchen Stromdichte ist eine erhebliche Erhitzung der Stromschiene verbunden.

Das zumindest eine diskrete Bauelement ist zumindest ein Kondensator. Der zweite Bereich kann mehrere diskrete Bauelemente aufweisen, wobei es sich hierbei um mehrere Kondensatoren handeln kann. Auch andere diskrete Bauelemente, beispielsweise Widerstände, können im zweiten Bereich angeordnet sein.

In dem ersten Bereich ist zumindest eine Induktivität angeordnet, die die Stromschiene umschließt, wenn die Stromschiene durch den ersten Bereich durchgeführt ist. Bei der Induktivität kann es sich um einen magnetischen Kern handeln. Bei der Induktivität kann es sich insbesondere um einen Ferrit-Kern oder einen nanokristallinen Kern handeln. Die Induktivität kann eine Röhre umschließen, durch die die zumindest eine Stromschiene durchgeführt werden kann. Weist der erste Bereich mehrere Röhren auf, durch die jeweils eine Stromschiene hindurchgeführt werden kann, so kann die Induktivität sämtliche Röhren des ersten Bereichs umschließen.

Der erste Bereich kann mehrere Induktivitäten aufweisen, die mit dem zumindest einen diskreten Bauelement und gegebenenfalls mit weiteren diskreten Bauelementen verschaltet sind. Die Induktivität und das zumindest eine diskrete Bauelement können zu einer LC-Filterschaltung verschaltet sein.

Der erste Bereich weist eine Röhre auf, die sich durch den ersten Bereich erstreckt und die zur Aufnahme der Stromschiene geeignet ist. Der erste Bereich kann mehrere Röhren aufweisen, wobei jede der Röhren zur Aufnahme einer Stromschiene geeignet ist. Die Röhren können die Stromschienen führen und derart ausgestaltet sein, dass sie eine elektrische Kontaktierung der Stromschiene mit dem Bauteil ermöglichen.

Die Röhre ist derart dimensioniert, dass eine Innenwand der Röhre und die Stromschiene durch eine Luftschicht voneinander getrennt sind. Die Luftschicht zwischen der Innenwand der Röhre und der Stromschiene kann zusätzlich zu dem Kühlbereich zu einer thermischen Isolierung der Stromschiene beitragen. Die Luftschicht kann dafür sorgen, dass von der Stromschiene abgestrahlte Hitze nur in gedämpftem Maße auf die Innenwand der Röhre übertragen wird.

Das zumindest eine diskrete Bauelement kann über ein Kabel oder ein Printed Circuit Board (PCB) mit der Röhre elektrisch verbunden sein. Die Verbindung des zumindest einen Bauelementes über ein Kabel kann dabei derart ausgestaltet sein, dass Vibrationen der Stromschiene nicht in vollem Umfang auf das diskrete Bauelement übertragen werden. Vielmehr kann die Verbindung der Röhre mit den diskreten Bauelementen über das Kabel für eine mechanische Entkopplung zwischen der Stromschiene und den Bauelementen sorgen. Dazu kann das Kabel ein ausreichendes Spiel aufweisen. Wird statt des Kabels ein PCB zur Verbindung des zumindest einen diskrete Bauelements mit der Röhre verwendet, so kann auch das PCB dafür sorgen, dass Vibrationen der Stromschiene nicht in vollem Umfang auf das diskrete Bauelement übertragen werden. Ein PCB ist typischerweise flexibel und kann dementsprechend die Vibrationen aufnehmen und dämpfen.

Insbesondere bei Anwendungen im Automotivebereich kann die Stromschiene mechanischen Störungen, beispielsweise Vibrationen, oder erheblichen mechanischen Kräften ausgesetzt werden. Durch die Ausgestaltung des Bauteils, bei der die Röhre und die diskreten Bauelemente über Kabel miteinander verbunden sind, kann es ermöglicht werden, dass die diskreten Bauelemente vor diese mechanischen Störungen und den mechanischen Kräften geschützt werden.

Das Kabel kann durch den Kühlbereich verlaufen. Wird das Kabel an seiner Anschlussstelle durch die Stromschiene erheblich erhitzt, kann es innerhalb des Kühlbereichs abgekühlt werden, sodass das Kabel die von der Stromschiene abgegebene Hitze nicht in vollem Umfang an die diskreten Bauelemente weitergibt. Dementsprechend kann der Kühlbereich dafür sorgen, dass eine elektrische Verbindung zwischen den diskreten Bauelementen und der Stromschiene besteht, ohne dass es zu einer Überhitzung der Bauelemente kommt. Da der durch den Kühlbereich das Volumen des Bauteils nicht wesentlich erhöht wird, kann der Kühlbereich weiter eine Miniaturisierung des Bauteils ermöglichen.

Die Röhre kann ein isolierendes Material und elektrisch leitfähige Kontakte für die Verbindung mit dem Kabel aufweisen. Die Röhre kann es dementsprechend ermöglichen, die Stromschienen gegenüber den weiteren Bestandteilen des Bauteils zu isolieren.

Das Kabel kann derart mit der Röhre verbunden sein, dass der erste Bereich und der zweite Bereich mechanisch entkoppelt sind. Dementsprechend werden Vibrationen der Stromschienen und Kräfte, die auf die Stromschienen wirken, nicht auf das zumindest eine diskrete Bauelement übertragen. Auf diese Weise können mechanische Beschädigungen verhindert werden und die Lebensdauer erhöht werden.

Das Kabel kann über eine gefederte Verbindung mit der Röhre verbunden werden. Beispielsweise kann die gefederte Verbindung Schrauben mit einem Federmechanismus aufweisen.

Das Bauteil kann zumindest eine Stromschiene aufweisen, die im ersten Bereich angeordnet ist. Gemäß dieser Ausführungsform ist die Stromschiene Bestandteil des Bauteils. In alternativen Ausführungsformen ist die Stromschiene nicht Bestandteil des Bauteils. Hier ist die Stromschiene vielmehr Bestandteil einer weiteren Komponente, die mit dem Bauteil verschaltet wird.

Die Stromschiene kann aus Kupfer oder Aluminium bestehen. Das Bauteil kann mehrere, beispielsweise zwei, Stromschienen aufweisen.

Das Bauteil kann ein Filter-Bauteil, beispielsweise ein EMV-Filter, sein.

Im Folgenden sind vorteilhafte Aspekte beschrieben. Um eine Referenzierung zu erleichtern sind die Aspekte durchnummeriert. Merkmale der Aspekte sind nicht nur in Kombination mit dem speziellen Aspekt, auf den sie sich beziehen, sondern auch separat betrachtet relevant.
1. Filter-Bauteil,
   aufweisend
   einen ersten Bereich, der zur Durchführung von zumindest einer Stromschiene geeignet ist, und
   einen zweiten Bereich, in dem zumindest ein diskretes Bauelement angeordnet ist,
   wobei der erste Bereich und der zweite Bereich durch einen Kühlbereich voneinander getrennt sind, der den ersten Bereich thermisch von dem zweiten Bereich entkoppelt.
2. Filter-Bauteil gemäß Aspekt 1,
   wobei der Kühlbereich mit Luft gefüllt ist.
3. Filter-Bauteil gemäß einem der vorherigen Aspekte, wobei der Kühlbereich eine Schicht aus einem Kunststoff aufweist.
4. Filter-Bauteil gemäß einem der vorherigen Aspekte, wobei das zumindest eine diskrete Bauelement ein Kondensator ist.
5. Filter-Bauteil gemäß einem der vorherigen Aspekte,
   wobei in dem ersten Bereich zumindest eine Induktivität angeordnet ist, die die zumindest eine Stromschiene umschließt, wenn die zumindest eine Stromschiene durch den ersten Bereich durchgeführt ist.
6. Filter-Bauteil gemäß einem der vorherigen Aspekte,
   wobei der erste Bereich eine Röhre aufweist, die sich durch den ersten Bereich erstreckt und die zur Aufnahme der zumindest einen Stromschiene geeignet ist.
7. Filter-Bauteil gemäß dem vorherigen Aspekt,
   wobei die Röhre derart dimensioniert ist, dass eine Innenwand der Röhre und die zumindest eine Stromschiene durch eine Luftschicht voneinander getrennt sind.
8. Filter-Bauteil gemäß einem der Aspekte 6 oder 7,
   wobei das zumindest eine diskrete Bauelemente über ein Kabel oder eine Leiterplatte mit der Röhre elektrisch verbunden ist.
9. Filter-Bauteil gemäß dem vorherigen Aspekt,
   wobei das Kabel durch den Kühlbereich verläuft.
10. Filter-Bauteil gemäß einem der Aspekte 8 oder 9,
   wobei die Röhre ein isolierendes Material und elektrisch leitfähige Kontakte für die Verbindung mit dem Kabel aufweist.
11. Filter-Bauteil gemäß einem der Aspekte 8 bis 10,
   wobei das Kabel derart mit der Röhre verbunden werden kann, dass der erste Bereich und der zweite Bereich mechanisch entkoppelt sind.
12. Filter-Bauteil gemäß einem der Aspekte 8 bis 11,
   wobei das Kabel über eine gefederte Verbindung mit der Röhre verbunden werden kann.
13. Filter-Bauteil gemäß einem der vorherigen Aspekte,
   wobei das Filter-Bauteil zumindest eine Stromschiene aufweist, die im ersten Bereich angeordnet ist.
14. Filter-Bauteil gemäß einem der vorherigen Aspekte,
   wobei das Filter-Bauteil ein EMV Filter ist.

Im Folgenden wird die vorliegende Erfindung anhand der beiliegenden Figuren näher erläutert.
Figur 1 zeigt ein Bauteil gemäß einem ersten Ausführungsbeispiel in einer schematischen Ansicht.
Figur 2 zeigt ein Bauteil gemäß einem zweiten Ausführungsbeispiel in einer schematischen Ansicht.
Figur 3 zeigt einen Querschnitt durch einen Teil des Bauteils gemäß dem zweiten Ausführungsbeispiel.
Figur 4 zeigt eine Verschaltung des Bauteils mit einem Motor und einer weiteren Komponente.

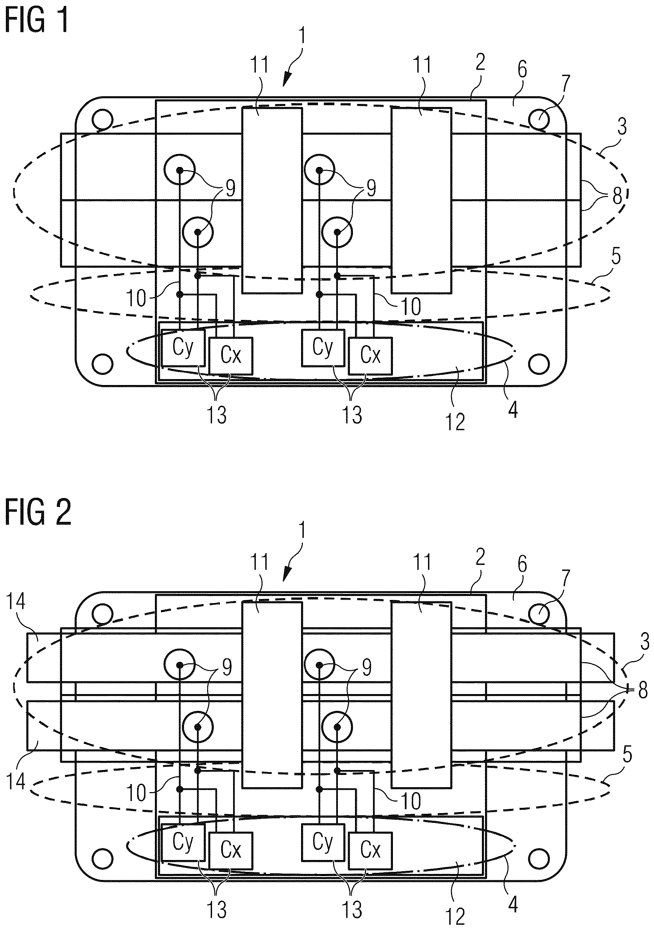

Figur 1 zeigt ein Bauteil 1. Das Bauteil 1 ist ein Filter-Bauteil.

Das Bauteil 1 weist ein Gehäuse 2 auf. Ein Innenraum des Gehäuses 2 ist in einen ersten Bereich 3, einen zweiten Bereich 4 und einen Kühlbereich 5 unterteilt. Der Kühlbereich 5 ist zwischen dem ersten Bereich 3 und dem zweiten Bereich 4 angeordnet. Ferner weist das Bauteil 1 eine Kühlplatte 6 auf, an der das Gehäuse 2 befestigt ist. Die Kühlplatte 6 kann Hitze von dem Gehäuse 2 wegleiten. Ferner weist die Kühlplatte 6 Öffnungen 7 auf, die eine mechanische Befestigung des Bauteils 1 ermöglichen.

Der erste Bereich 3 ist dazu ausgestaltet, dass zwei Stromschienen durch den ersten Bereich 3 hindurch geführt werden. Die Stromschienen sind dabei nicht Bestandteil des Bauteils 1, sondern gehören zu einer externen Komponente, die mit dem Bauteil 1 verschaltet werden kann. Der erste Bereich 3 weist zwei Röhren 8 auf, wobei durch jede der Röhren 8 jeweils eine Stromschiene hindurch geführt werden kann.

Die Röhren 8 weisen ein isolierendes Material und leitfähige Kontakte 9 auf, an die jeweils ein Kabel 10 angeschlossen ist. Über die Kontakte 9 und die Kabel 10 können in den Röhren 8 angeordneten Stromschienen elektrisch kontaktiert werden. Alternativ zu den Kabeln 10 könnten Leiterplatten (PCB) verwendet werden, um die Kontakte 9 der Röhre 8 zu kontaktieren.

Bei dem in Figur 1 gezeigten Ausführungsbeispiel weist jede Röhre 8 zwei leitfähige Kontakte 9 auf. In alternativen Ausführungsbeispielen kann jede Röhre 8 nur einen Kontakt 9 oder mehr als zwei Kontakte 9 aufweisen.

Die Röhren 8 weisen einen rechteckigen Querschnitt auf. Dabei weisen die Röhren 8 vier Seitenwände auf, wobei einander benachbarte Seitenwände jeweils senkrecht aufeinander stehen. Die Seitenwände bestehen aus dem isolierenden Material, wobei an einer der Seitenwände die leitfähigen Kontakte 9 angeordnet sind.

Ferner weist der erste Bereich 3 zwei Induktivitäten 11 auf. Bei den Induktivitäten 11 handelt es sich um ringförmige magnetische Kerne, die aus einem Ferrit bestehen. Alternativ kann es sich bei den Induktivitäten 11 um nanokristalline Kerne handeln. Jede der Induktivitäten 11 umschließt die beiden Röhren 8. Dementsprechend können die Induktivitäten 11 über eine induktive Kopplung mit Stromschienen, die innerhalb der Röhren 8 angeordnet sind, wechselwirken, wenn ein Strom durch die Stromschienen fließt.

Der zweite Bereich 4 weist eine Leiterplatte 12 auf. Auf der Leiterplatte 12 sind mehrere diskrete Bauelemente 13 angeordnet. Bei den diskreten Bauelementen 13 handelt es sich um Kondensatoren.

Die Leiterplatte 12 ist mit den Kabeln 10, die an die Kontakte 9 der Röhren 8 angeschlossen sind, elektrisch verbunden. Dementsprechend sind auch die diskreten Bauelemente 13 mit der Stromschiene verschaltet.

Die diskreten Bauelemente 13 und die Induktivitäten 11 bilden eine Filter-Schaltung. In alternativen Ausführungsbeispielen können die Anzahl der diskreten Bauelemente 13 und der Induktivitäten 11 variiert werden. Das Bauteil 1 weist zumindest eine Induktivität 11 oder zumindest einen Kondensator auf. Das Bauteil 1 kann auch mehrere Induktivitäten 11 und/oder mehrere diskreten Bauelemente 13, z.B. mehrere Kondensatoren, aufweisen.

Die Kabel 10, die die Röhren 8 und die Leiterplatte 12 miteinander verbindet, weisen ein gewisses Spiel auf und stehen nicht unter Spannung. Dementsprechend werden Vibrationen oder Kräfte, die auf die Röhren 8 wirken, über die Kabel 10 nicht oder zumindest nur in sehr geringem Umfang auf die Leiterplatte 12 und die diskreten Bauelemente 13 übertragen. Dementsprechend können die diskreten Bauelemente 13 durch die nicht unter mechanischer Spannung stehenden Kabel 10 vor Beschädigungen durch Kräfte, die auf die Röhren 8 oder auf in den Röhren 8 angeordnete Stromschienen wirken, geschützt werden.

Ferner weist das Bauteil 1 den oben genannten Kühlbereich 5 auf. Bei dem in Figur 1 gezeigten Ausführungsbeispiel ist der Kühlbereich 5 mit Luft gefüllt. Alternativ oder ergänzend kann in dem Kühlbereich 5 eine Schicht eines Materials angeordnet sein, das als thermischer Isolator wirkt. Der Kühlbereich 5 sorgt für eine thermische Entkopplung des zweiten Bereichs 4 von dem ersten Bereich 3. In dem ersten Bereich 3 kann es zu hohen Temperaturen kommen, da die Stromschienen sehr heiß werden können. Bei Anwendungen im Automotive-Bereich sind beispielsweise Stromdichten von mehr als 3 A/mm² üblich. Der Kühlbereich 5 sorgt dafür, dass diese Temperaturen nur in abgemilderter Form den zweiten Bereich 4 erreichen, so dass bei einer Erhitzung des ersten Bereichs 3 eine Temperatur des zweiten Bereichs 4 um zumindest 10° C, vorzugsweise zumindest 25° C, geringer ist als die Temperatur des ersten Bereichs 3.

Figur 2 zeigt ein Bauteil 1 gemäß einem zweiten Ausführungsbeispiel in einer schematischen Ansicht. Das Bauteil 1 gemäß dem zweiten Ausführungsbeispiel unterscheidet sich von dem in Figur 1 gezeigten Ausführungsbeispiel dadurch, dass es zwei Stromschienen 14 aufweist, die Bestandteil des Bauteils 1 sind. Die Stromschienen 14 können über entsprechende Anschlüsse mit weiteren Komponenten verbunden werden. Die Stromschienen 14 verlaufen parallel zueinander, wobei jede der Stromschienen 14 in genau einer Röhre 8 angeordnet ist. Jede der Stromschienen 14 ist mit je zwei leitfähigen Kontakten 9 verbunden, die jeweils über ein Kabel 10 mit dem zweiten Bereich 4 kontaktiert sind. Die Stromschienen 14 können aus Kupfer oder Aluminium bestehen.

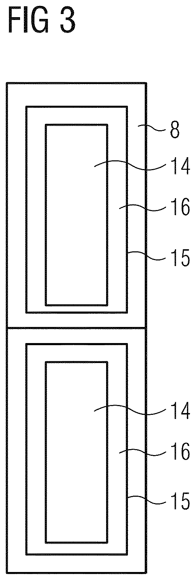

Figur 3 zeigt einen Querschnitt durch die beiden Röhren 8 des Bauteils 1 gemäß dem zweiten Ausführungsbeispiel. Die Röhren 8 sind derart dimensioniert, dass jeweils zwischen der Stromschiene 14, die in der Röhre 8 angeordnet ist, und einer Innenwand 15 der Röhre 8 eine Luftschicht 16 verbleibt. Diese Luftschicht 16 wirkt als thermischer Isolator und sorgt dafür, dass die Innenwand 15 der Röhren 8 weniger stark erhitzt wird, als dies der Fall wäre, wenn die Stromschienen 14 unmittelbar an der Innenwand 15 anliegen würden.

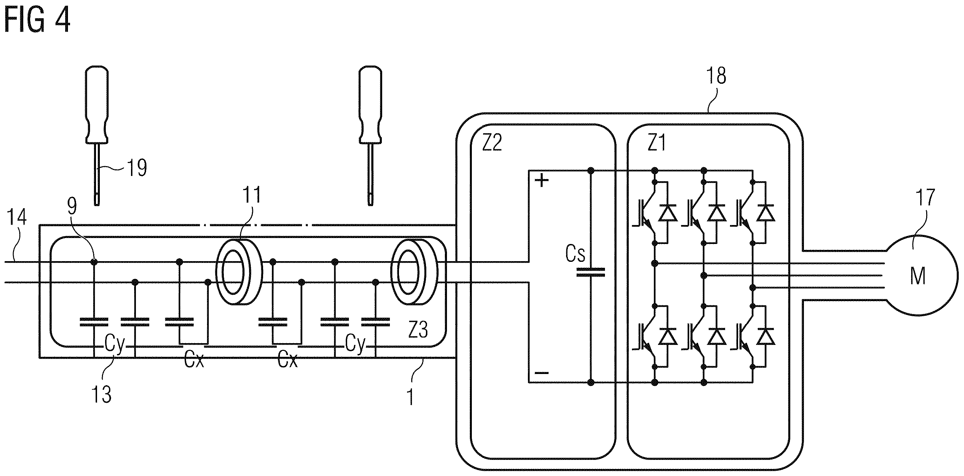

Figur 4 zeigt eine Verschaltung des Bauteils 1 gemäß dem ersten Ausführungsbeispiel mit einem Motor 17 und einer weiteren Komponente 18. Bei der weiteren Komponente 18 handelt es sich hier um einen Inverter.

Die weitere Komponente 18 weist zwei Stromschienen 14 auf, die durch das Bauteil 1 geführt werden. Bei dem hier gezeigten Ausführungsbeispiel ist jede der Stromschienen 14 durch vier Kontakte 9 mit dem zweiten Bereich 4 elektrisch verbunden.

In Figur 4 ist ferner angedeutet, dass die Kontakte über eine gefederte Verbindung 19, insbesondere eine gefederte Schraubverbindung, geschlossen werden können. Die gefederte Verbindung 19 kann Kräfte die auf die Stromschienen 14 wirken abfedern und dafür sorgen, dass die Kräfte nicht auf die Leiterplatte 12 übertragen werden. Ferner kann die gefederte Verbindung 19 das Gewicht der Stromschienen 14 abfedern und so den zweiten Bereich 4 und die Anschlüsse der weiteren Komponente 18 mechanisch entlasten.

### Bezugszeichenliste

- 1: Bauteil
- 2: Gehäuse
- 3: erster Bereich
- 4: zweiter Bereich
- 5: Kühlbereich
- 6: Kühlplatte
- 7: Öffnung
- 8: Röhre
- 9: Kontakt
- 10: Kabel
- 11: Induktivität
- 12: Leiterplatte
- 13: diskretes Bauelement
- 14: Stromschiene
- 15: Innenwand
- 16: Luftschicht
- 17: Motor
- 18: weitere Komponente
- 19: gefederte Verbindung

## Patentansprüche

1. Bauteil (1),
aufweisend
einen ersten Bereich (3), der zur Durchführung von zumindest einer Stromschiene (14) geeignet ist, und einen zweiten Bereich (4), in dem zumindest ein Kondensator angeordnet ist,
wobei der erste Bereich (3) und der zweite Bereich (4) durch einen Kühlbereich (5) voneinander getrennt sind, der den ersten Bereich (3) thermisch von dem zweiten Bereich (4) entkoppelt,
wobei in dem ersten Bereich (3) zumindest eine Induktivität angeordnet ist, die die zumindest eine Stromschiene (14) umschließt, wenn die zumindest eine Stromschiene (14) durch den ersten Bereich (3) durchgeführt ist,
wobei der erste Bereich (3) eine Röhre (8) aufweist, die sich durch den ersten Bereich (3) erstreckt und die zur Aufnahme der zumindest einen Stromschiene (14) geeignet ist,
wobei die Röhre (8) derart dimensioniert ist, dass eine Innenwand (15) der Röhre (8) und die zumindest eine Stromschiene (14) durch eine Luftschicht (16) voneinander getrennt sind,
wobei die Röhre (8) ein isolierendes Material und leitfähige Kontakte (9) aufweist, an die jeweils ein Kabel (10) angeschlossen ist, wobei über die Kontakte (9) und die Kabel (10) die zumindest eine Stromschiene (14) elektrisch kontaktiert wird, wenn diese in der Röhre (8) angeordnete ist.

2. Bauteil (1) gemäß Anspruch 1,
wobei der Kühlbereich (5) mit Luft gefüllt ist.

3. Bauteil (1) gemäß einem der vorherigen Ansprüche,
wobei der Kühlbereich (5) eine Schicht aus einem Kunststoff aufweist.

4. Bauteil (1) gemäß einem der vorherigen Ansprüche,
wobei der zumindest eine Kondensator über das Kabel (10) oder eine Leiterplatte mit der Röhre (8) elektrisch verbunden ist.

5. Bauteil (1) gemäß einem der vorherigen Ansprüche,
wobei das Kabel (10) durch den Kühlbereich (5) verläuft.

6. Bauteil (1) gemäß einem der vorherigen Ansprüche,
wobei das Kabel (10) derart mit der Röhre (8) verbunden werden kann, dass der erste Bereich (3) und der zweite Bereich (4) mechanisch entkoppelt sind.

7. Bauteil (1) gemäß einem der vorherigen Ansprüche,
wobei das Kabel (10) über eine gefederte Verbindung (19) mit der Röhre (8) verbunden werden kann.

8. Bauteil (1) gemäß einem der vorherigen Ansprüche,
wobei das Bauteil (1) zumindest eine Stromschiene (14) aufweist, die im ersten Bereich (3) angeordnet ist.

9. Bauteil (1) gemäß einem der vorherigen Ansprüche,
wobei das Bauteil (1) ein Filter-Bauteil ist.

10. Bauteil (1) gemäß einem der vorherigen Ansprüche,
wobei das Bauteil (1) ein EMV Filter ist.

## Claims

1. Component (1),
comprising
a first region (3) suitable for feedthrough of at least one busbar (14), and
a second region (4), in which at least one capacitor is arranged,
wherein the first region (3) and the second region (4) are separated from one another by a cooling region (5), which thermally decouples the first region (3) from the second region (4),
wherein there is arranged in the first region (3) at least one inductance which encloses the at least one busbar (14) when the at least one busbar (14) is fed through the first region (3),
wherein the first region (3) comprises a tube (8) extending through the first region (3) and suitable for receiving the at least one busbar (14),
wherein the tube (8) is dimensioned such that an inner wall (15) of the tube (8) and the at least one busbar (14) are separated from one another by an air layer (16),
wherein the tube (8) comprises an insulating material and conductive contacts (9), to each of which a cable (10) is connected, wherein the at least one busbar (14) is electrically contacted via the contacts (9) and the cables (10) when it is arranged in the tube (8).

2. Component (1) according to Claim 1,
wherein the cooling region (5) is filled with air.

3. Component (1) according to either of the preceding claims,
wherein the cooling region (5) comprises a layer comprised of a plastic.

4. Component (1) according to any of the preceding claims,
wherein the at least one capacitor is electrically connected to the tube (8) via the cable (10) or a printed circuit board.

5. Component (1) according to any of the preceding claims,
wherein the cable (10) runs through the cooling region (5).

6. Component (1) according to any of the preceding claims,
wherein the cable (10) can be connected to the tube (8) in such a way that the first region (3) and the second region (4) are mechanically decoupled.

7. Component (1) according to any of the preceding claims,
wherein the cable (10) can be connected to the tube (8) via a resilient connection (19).

8. Component (1) according to any of the preceding claims,
wherein the component (1) comprises at least one busbar (14) arranged in the first region (3).

9. Component (1) according to any of the preceding claims,
wherein the component (1) is a filter component.

10. Component (1) according to any of the preceding claims,
wherein the component (1) is an EMC filter.

## Revendications

1. Composant (1), comportant
une première zone (3) qui est adaptée au passage d'au moins une barre conductrice (14) et
une deuxième zone (4) dans laquelle est disposé au moins un condensateur,
la première zone (3) et la deuxième zone (4) étant séparées l'une de l'autre par une zone de refroidissement (5) qui découple thermiquement la première zone (3) de la deuxième zone (4),
au moins une inductance étant disposée dans la première zone (3) et enfermant l'au moins une barre conductrice (14) lorsque l'au moins une barre conductrice (14) passe à travers la première zone (3),
la première zone (3) comportant un tube (8) qui s'étend à travers la première zone (3) et qui est adapté pour recevoir l'au moins une barre conductrice (14),
le tube (8) étant dimensionné de manière qu'une paroi intérieure (15) du tube (8) et l'au moins une barre conductrice (14) soient séparées l'une de l'autre par une couche d'air (16),
le tube (8) comportant un matériau isolant et des contacts conducteurs (9) à chacun desquels est raccordé un câble (10), l'au moins une barre conductrice (14) établissant un contact électrique par le biais des contacts (9) et des câbles (10) lorsqu'elle est disposée dans le tube (8).

2. Composant (1) selon la revendication 1,
la zone de refroidissement (5) étant remplie d'air.

3. Composant (1) selon l'une des revendications précédentes,
la zone de refroidissement (5) comportant une couche de matière synthétique.

4. Composant (1) selon l'une des revendications précédentes,
l'au moins un condensateur étant relié électriquement au tube (8) par le biais du câble (10) ou d'une carte de circuit imprimé.

5. Composant (1) selon l'une des revendications précédentes,
le câble (10) s'étendant à travers la zone de refroidissement (5).

6. Composant (1) selon l'une des revendications précédentes,
le câble (10) pouvant être relié au tube (8) de manière que la première zone (3) et la deuxième zone (4) soient découplées mécaniquement.

7. Composant (1) selon l'une des revendications précédentes,
le câble (10) pouvant être relié au tube (8) par le biais d'une liaison à ressort (19).

8. Composant (1) selon l'une des revendications précédentes,
le composant (1) comportant au moins une barre conductrice (14) qui est disposée dans la première zone (3) .

9. Composant (1) selon l'une des revendications précédentes,
le composant (1) étant un composant formant filtre.

10. Composant (1) selon l'une des revendications précédentes,
le composant (1) étant un filtre de compatibilité électromagnétique.
